(19) Europäisches Patentamt
European Patent Office
Office européen des brevets

(11) **EP 3 171 185 B1**

(12) **EUROPÄISCHE PATENTSCHRIFT**

(45) Veröffentlichungstag und Bekanntmachung des Hinweises auf die Patenterteilung:
**27.06.2018 Patentblatt 2018/26**

(51) Int Cl.:
***G01R 31/08*** *(2006.01)*     *G01R 31/02* *(2006.01)*

(21) Anmeldenummer: **15195561.4**

(22) Anmeldetag: **20.11.2015**

(54) **VERFAHREN UND EINRICHTUNG ZUM BESTIMMEN DES FEHLERORTES IM FALLE EINES FEHLERS AUF EINER ELEKTRISCHEN LEITUNG**

METHOD AND DEVICE FOR DETERMINING THE FAULT LOCATION IN THE EVENT OF A FAULT ON AN ELECTRIC LINE

PROCEDE ET DISPOSITIF DE DETERMINATION DE LOCALISATION DE PANNE EN CAS DE PANNE SUR UNE LIGNE ELECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**24.05.2017 Patentblatt 2017/21**

(73) Patentinhaber: **Siemens Aktiengesellschaft 80333 München (DE)**

(72) Erfinder: **Jurisch, Andreas 16727 Schwante (DE)**

(56) Entgegenhaltungen:
**DE-T2- 3 687 451    DE-T2- 68 916 495**

• **JOE-AIR JIANG ET AL: "An adaptive PMU based fault detection/location technique for transmission lines. I. Theory and algorithms", IEEE TRANSACTIONS ON POWER DELIVERY., Bd. 15, Nr. 2, 1. April 2000 (2000-04-01), Seiten 486-493, XP055274841, US ISSN: 0885-8977, DOI: 10.1109/61.852973**

**Beschreibung**

Die Erfindung bezieht sich auf ein Verfahren zum Bestimmen des Fehlerortes im Falle eines Fehlers, insbesondere Kurzschlusses, auf einer elektrischen Leitung oder einem Leitungsabschnitt der elektrischen Leitung, wobei mit Strom- und Spannungsabtastwerten an einem Leitungsende der Leitung oder des Leitungsabschnitts, nachfolgend erstes Leitungsende genannt, und dem Wellenwiderstand der Leitung erste Referenzspannungswerte ermittelt werden, mit Strom- und Spannungsabtastwerten an dem anderen Leitungsende der Leitung oder des Leitungsabschnitts, nachfolgend zweites Leitungsende genannt, und dem Wellenwiderstand der Leitung zweite Referenzspannungswerte ermittelt werden, anhand eines das Wellenübertragungsverhalten der Leitung beschreibenden Wellenleitungsmodells mit den ersten Referenzspannungswerten fiktive erste Referenzspannungswerte berechnet werden, die im fehlerfreien Fall den zweiten Referenzspannungswerten am zweiten Leitungsende entsprechen, und mit den zweiten Referenzspannungswerten fiktive zweite Referenzspannungswerte berechnet werden, die im fehlerfreien Fall den ersten Referenzspannungswerten am ersten Leitungsende entsprechen, und mit den ersten und zweiten Referenzspannungswerten und den ersten und zweiten fiktiven Referenzspannungswerten der Fehlerort ermittelt wird.

Verfahren zur Fehlerortung sind beispielsweise aus der DE 689 16 495 T2 oder DE 36 87 451 T2 bekannt.

Bekannt ist ein Fehlerortungsverfahren, bei dem eine Fehlerortung anhand von für die Netzfrequenz ermittelten Spannungszeigern und Stromzeigern erfolgt. In diesem Zusammenhang sei beispielsweise die US-Patentschrift US 5,929,642 erwähnt; bei dem dort beschriebenen Verfahren wird unter Verwendung der Strom- und Spannungszeiger von beiden Leitungsenden mithilfe von Schätzverfahren und nichtlinearen Optimierungsverfahren eine recht hohe Ortungsgenauigkeit (Messfehler ca. 1 % bis 2 %) bei der Fehlerortung erreicht.

Darüber hinaus ist bekannt, die bei einem Fehlereintritt auftretenden Stromflanken des über die Leitung propagierenden Fehlerstromsignals auszuwerten (vgl. US-Patent 8,655,609 B2). Bei dieser Ortungsvariante ist es jedoch zwingend nötig, dass identifizierbare Stromflanken im Stromsignal auftreten. Ist dies nicht der Fall, können Messfehler auftreten.

Der Erfindung liegt die Aufgabe zugrunde, ein Fehlerortungsverfahren anzugeben, bei dem eine hohe Ortungsgenauigkeit unabhängig von eindeutig identifizierbaren Stromflanken erreichbar ist.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass durch Differenzbildung zwischen den zweiten fiktiven Referenzspannungswerten und den ersten Referenzspannungswerten ein erstes fiktives Fehlerspannungssignal und durch Differenzbildung zwischen den ersten fiktiven Referenzspannungswerten und den zweiten Referenzspannungswerten ein zweites fiktive Fehlerspannungssignal ermittelt wird, die beiden fiktiven Fehlerspannungssignale einer Kreuzkorrelation unterzogen werden und eine Kreuzkorrelationsfunktion ermittelt wird und anhand der Kreuzkorrelationsfunktion der Fehlerort ermittelt wird, indem der Fehlerort anhand der zeitlichen Verschiebung des Maximums der Kreuzkorrelationsfunktion gegenüber der Mittelposition im Ergebnisfenster der Kreuzkorrelationsfunktion bestimmt wird.

Bei dem erfindungsgemäßen Verfahren wird die Erkenntnis genutzt, dass - wie bei dem oben beschriebenen Ortungsverfahren mit Flankenerkennung - im Falle eines Fehlers Fehlerströme mit relativ hohen Frequenzen auftreten. Erfindungsgemäß ist es - im Unterschied zu dem Ortungsverfahren mit Flankenerkennung - jedoch irrelevant, ob sich dabei verwertbare Stromflanken bilden oder nicht; unabhängig von der Form des auftretenden Fehlerstromsignals kann bei dem erfindungsgemäßen Verfahren nämlich allein anhand der Referenzspannungswerte und der fiktiven Referenzspannungswerte stets eine sehr genaue Ortungsbestimmung erfolgen, also auch bei wenig oder nicht ausgeprägten Stromflanken. Dies ist bei dem erfindungsgemäßen Verfahren möglich, weil die Fehlerortung anhand von Referenzspannungswerten und fiktiven Referenzspannungswerten erfolgt, die auf der Basis von gemessenen Spannungswerten und mit dem Wellenwiderstand der Leitung verknüpften Stromwerten sowie eines das Wellenübertragungsverhalten der Leitung beschreibenden Wellenleitungsmodells ermittelt werden; die Referenzspannungswerte und die fiktiven Referenzspannungswerte beschreiben für sich keine physikalisch existierende Größe, sondern bilden lediglich künstliche Hilfsrechengrößen, dennoch - und dort liegt der erfinderische Gedanke - ermöglichen sie auf der Grundlage des Wellenleitungsmodells, also beispielsweise auf der Grundlage der aus der Hochfrequenztechnik bekannten Telegraphengleichung, eine genaue Fehlerortung auch dann, wenn sich keine für eine Laufzeitdifferenzauswertung geeigneten bzw. ausreichend steilen Stromflanken bilden. Erfindungsgemäß lässt sich mit den ersten und zweiten Referenzspannungswerten und den ersten und zweiten fiktiven Referenzspannungswerten der Fehlerort ermitteln, indem durch Differenzbildung zwischen den zweiten fiktiven Referenzspannungswerten und den ersten Referenzspannungswerten ein erstes fiktives Fehlerspannungssignal und durch Differenzbildung zwischen den ersten fiktiven Referenzspannungswerten und den zweiten Referenzspannungswerten ein zweites fiktives Fehlerspannungssignal ermittelt wird. Die beiden fiktiven Fehlerspannungssignale werden einer Kreuzkorrelation unterzogen und es wird eine Kreuzkorrelationsfunktion ermittelt. Anhand der Kreuzkorrelationsfunktion lässt sich der Fehlerort einfach und genau ermitteln.

Hierbei wird der Fehlerort anhand der zeitlichen Verschiebung des Maximums der Kreuzkorrelationsfunktion gegenüber der Mittelposition im Ergebnisfenster der Kreuzkorrelationsfunktion bestimmt.

Mit den beiden fiktiven Fehlerspannungssignalen wird die Kreuzkorrelationsfunktion φ(τ) bevorzugt gebildet gemäß:

$$\varphi(\tau) = \frac{1}{T} \sum_{-\frac{T}{2}}^{\frac{T}{2}} UFS1(t) \cdot UFS2(t + \tau)$$

wobei T die zeitliche Länge des Ergebnisfensters der Kreuzkorrelationsfunktion φ(τ) bezeichnet und *UFS1* und *UFS2* die fiktiven Fehlerspannungssignalen bezeichnen.

Bei einer besonders bevorzugten Ausgestaltung des Verfahrens ist vorgesehen, dass anhand der zeitlichen Verschiebung des Maximums der Kreuzkorrelationsfunktion gegenüber der Mittelposition im Ergebnisfenster der Kreuzkorrelationsfunktion ein Laufzeitdifferenzwert bestimmt wird, der die Laufzeit der Welle des Fehlerstroms von der Fehlerstelle zu dem jeweiligen von der Kreuzkorrelationsfunktion als Referenzleitungsende herangezogenen Leitungsende angibt.

Der Zeitversatz τ, für den die Kreuzkorrelationsfunktion φ(τ) maximal wird, kann mit anderen Worten als Maß für den zeitlichen Versatz, mit dem der Fehlerstrom am Fehlerort der elektrischen Leitung an dem ersten Leitungsende und dem zweiten Leitungsende sichtbar wird, genutzt werden.

Der Fehlerort kann zum Beispiel in Form eines Abstandswertes bestimmt werden gemäß:

$$LF = \frac{(\text{Im}(\gamma) \cdot l) + (TA - TC)}{2 \cdot \text{Im}(\gamma) \cdot l}$$

wobei Im(γ) den Imaginärteil der komplexen Ausbreitungskonstanten γ auf der Leitung, *l* die Leitungslänge der Leitung und TA-TC den Zeitversatz τ, für den die Kreuzkorrelationsfunktion φ(τ) maximal wird, und LF den Abstand zum Fehlerort bezeichnet.

Auch ist es vorteilhaft, wenn mit den fiktiven Fehlerspannungssignalen ggf. Kurzschlusswarnsignale erzeugt werden. Demgemäß ist bei einer bevorzugten Ausgestaltung des Verfahrens vorgesehen, dass die fiktiven Fehlerspannungssignale jeweils mit einem Spannungsschwellenwert verglichen werden und ein einen Kurzschluss auf der elektrischen Leitung anzeigendes Kurzschlusswarnsignal erzeugt wird, wenn beide fiktiven Fehlerspannungssignale oder zumindest eines den Spannungsschwellenwert erreicht oder überschreitet. Die beiden fiktiven Fehlerspannungssignale werden bevorzugt ausschließlich dann der Kreuzkorrelation unterzogen und die Kreuzkorrelationsfunktion wird bevorzugt ausschließlich dann ermittelt, wenn das Kurzschlusswarnsignal erzeugt worden ist bzw. der Spannungsschwellenwert erreicht oder überschritten worden ist.

Die ersten Referenzspannungswerte werden bevorzugt ermittelt gemäß:

$$U1 = (Ua + Ia \cdot Z(j\omega))$$

wobei *U1* die ersten Referenzspannungswerte, *Ua* Spannungswerte vom ersten Leitungsende und *Ia* Stromwerte vom ersten Leitungsende und *Z(jω)* den Wellenwiderstand bezeichnet.

Die zweiten Referenzspannungswerte werden bevorzugt ermittelt gemäß:

$$U2 = (Uc + Ic \cdot Z(j\omega))$$

wobei *U2* die zweiten Referenzspannungswerte, *Uc* Spannungswerte vom zweiten Leitungsende und *Ic* Stromwerte vom zweiten Leitungsende bezeichnet.

Mit den ersten Referenzspannungswerten werden anhand des Wellenleitungsmodells die fiktiven ersten Referenzspannungswerte bevorzugt berechnet gemäß

$$U1' = U1 \cdot e^{j\gamma(j\omega)l}$$

wobei *U1'* die fiktiven ersten Referenzspannungswerte am ersten Leitungsende, *l* die Leitungslänge der Leitung, ω die

Kreisfrequenz und $\gamma$ die Wellenausbreitungskonstante auf der Leitung bezeichnet.

Mit den zweiten Referenzspannungswerten werden anhand des Wellenleitungsmodells die fiktiven zweiten Referenzspannungswerte bevorzugt berechnet gemäß

$$U2' = U2 \cdot e^{j \cdot \gamma (j\omega) l}$$

wobei $U2'$ die fiktiven zweiten Referenzspannungswerte am zweiten Leitungsende bezeichnet.
Durch Differenzbildung zwischen den zweiten fiktiven Referenzspannungswerten und den ersten Referenzspannungswerten wird das erste fiktive Fehlerspannungssignal vorzugsweise ermittelt gemäß:

$$UFS1 = U1 - U2' = U1 - U2 \cdot e^{j \cdot \gamma (j\omega) l}$$

wobei $UFS1$ das erste fiktive Fehlerspannungssignal bezeichnet.

Durch Differenzbildung zwischen den ersten fiktiven Referenzspannungswerten und den zweiten Referenzspannungswerten wird das zweite fiktive Fehlerspannungssignal bevorzugt ermittelt gemäß:

$$UFS2 = U2 - U1' = U2 - U1 \cdot e^{j \cdot \gamma (j\omega) l}$$

wobei $UFS2$ das zweite fiktive Fehlerspannungssignal bezeichnet.

Das erste und zweite fiktive Fehlerspannungssignal geben anschaulich beschrieben jeweils eine Spannung an, die dem Produkt aus dem Wellenwiderstand der Leitung und dem Fehlerstrom $I_F$ an der Fehlerstelle entspricht, also gilt:

$$UFS1 = I_F \cdot Z(j\omega)$$

$$UFS2 = I_F \cdot Z(j\omega)$$

Die Bestimmung der ersten und zweiten Referenzspannungswerte und/oder die Bestimmung der ersten und zweiten fiktiven Referenzspannungswerte kann im Frequenzbereich oder im Zeitbereich erfolgen.

Erfolgt die Berechnung im Frequenzbereich, so wird es als vorteilhaft angesehen, wenn bei der Bestimmung der ersten Referenzspannungswerte $U1$ der Term $Ia \cdot Z(j\omega)$ im Frequenzbereich errechnet wird, indem der Strom $Ia$ am ersten Leitungsende frequenzbezogen mit dem Wellenwiderstand $Z(j\omega)$, insbesondere frequenzabhängig, multipliziert wird, und wenn bei der Bestimmung der zweiten Referenzspannungswerte der Term $Ic \cdot Z(j\omega)$ im Frequenzbereich errechnet wird, indem der Strom $Ic$ am zweiten Leitungsende frequenzbezogen mit dem Wellenwiderstand $Z(j\omega)$, insbesondere frequenzabhängig, multipliziert wird.

Im Falle einer Berechnung im Frequenzbereich ist es außerdem von Vorteil, wenn mit den ersten Referenzspannungswerten $U1$ die fiktiven ersten Referenzspannungswerte $U1'$ im Frequenzbereich berechnet werden, indem die ersten Referenzspannungswerte $U1$ mit der Funktion $e^{j \cdot \gamma (j\omega) \cdot l}$ frequenzbezogen (bzw. frequenzindividuell) multipliziert werden, und mit den zweiten Referenzspannungswerten $U2$ die fiktiven zweiten Referenzspannungswerte $U2'$ im Frequenzbereich berechnet werden, indem die zweiten Referenzspannungswerte $U2$ mit der Funktion $e^{j \cdot \gamma (j\omega) \cdot l}$ frequenzbezogen multipliziert werden.

Erfolgt die Berechnung im Zeitbereich, so wird es als vorteilhaft angesehen, wenn bei der Bestimmung der ersten Referenzspannungswerte $U1$ der Term $Ia \cdot Z(j\omega)$ im Zeitbereich errechnet wird, indem die Stromabtastwerte des Stroms am ersten Leitungsende mit einem das Übertragungsverhalten des Wellenwiderstands $Z(j\omega)$ nachbildenden ersten Filter numerisch gefiltert werden, und wenn bei der Bestimmung der zweiten Referenzspannungswerte der Term $Ic \cdot Z(j\omega)$ im Zeitbereich errechnet wird, indem die Stromabtastwerte des Stroms am zweiten Leitungsende mit dem ersten Filter oder einem anderen das Übertragungsverhalten des Wellenwiderstands $Z(j\omega)$ nachbildenden Filter numerisch gefiltert werden.

Im Falle einer Berechnung im Zeitbereich ist es außerdem von Vorteil, wenn mit den ersten Referenzspannungswerten $U1$ die fiktiven ersten Referenzspannungswerte $U1'$ im Zeitbereich berechnet werden, indem die ersten Referenzspannungswerte $U1$ mit einem die Funktion $e^{j \cdot \gamma (j\omega) \cdot l}$ nachbildenden zweiten Filter numerisch gefiltert werden, und wenn mit den zweiten Referenzspannungswerten $U2$ die fiktiven zweiten Referenzspannungswerte $U2'$ im Zeitbereich berechnet werden, indem die zweiten Referenzspannungswerte $U2$ mit dem zweiten Filter oder einem anderen die Funktion $e^{j\cdot\gamma(j\omega)\cdot l}$ nachbildenden Filter numerisch gefiltert werden.

Soll die Frequenzabhängigkeit des Wellenwiderstands berücksichtigt werden, so ist es vorteilhaft, wenn das erste Filter ein IIR-Filter erster Ordnung und einen nachgeordneten Wurzelbildner umfasst und der Frequenzabhängigkeit des Wellenwiderstands der elektrischen Leitung Rechnung trägt.

Soll die Frequenzabhängigkeit des Wellenwiderstands unberücksichtigt bleiben, beispielsweise um Rechenleistung zu sparen, so ist es vorteilhaft, wenn das erste Filter ein Multiplizierelement umfasst, das die Stromabtastwerte mit einem konstanten Wellenwiderstandswert multipliziert.

Soll die Frequenzabhängigkeit der Dämpfung und die der Ausbreitungskonstanten (also die Dispersion der Leitung) berücksichtigt werden, so ist es vorteilhaft, wenn das zweite Filter ein FIR-Filter und/oder ein IIR-Filter umfasst oder durch ein solches gebildet ist.

Die Erfindung bezieht sich außerdem auf eine Fehlerortungseinrichtung zum Bestimmen des Fehlerortes im Falle eines Fehlers, insbesondere Kurzschlusses, auf einer elektrischen Leitung oder auf einem Leitungsabschnitt der elektrischen Leitung mit

- einem oder mehreren Referenzspannungsbildnern zur Bildung erster und zweiter Referenzspannungswerte anhand von Strom- und Spannungsabtastwerten an einem Leitungsende der Leitung oder des Leitungsabschnitts, nachfolgend erstes Leitungsende genannt, Strom- und Spannungsabtastwerten an dem anderen Leitungsende der Leitung oder des Leitungsabschnitts, nachfolgend zweites Leitungsende genannt, und dem Wellenwiderstand der Leitung,
- einem oder mehreren Propagationsnachbildnern zur Bildung fiktiver erster und fiktiver zweiter Referenzspannungswerte anhand eines das Wellenübertragungsverhalten der Leitung beschreibenden Wellenleitungsmodells sowie den ersten und zweiten Referenzspannungswerten, wobei die fiktiven ersten Referenzspannungswerte im fehlerfreien Fall den zweiten Referenzspannungswerten am zweiten Leitungsende (22) entsprechen und die fiktiven zweiten Referenzspannungswerte im fehlerfreien Fall den ersten Referenzspannungswerten am ersten Leitungsende entsprechen, und
- einer Auswerteinheit, die mit den ersten und zweiten Referenzspannungswerten und den ersten und zweiten fiktiven Referenzspannungswerten oder mit ersten und zweiten fiktiven Fehlerspannungssignalen, die mit den ersten und zweiten Referenzspannungswerten und den ersten und zweiten fiktiven Referenzspannungswerten gebildet worden sind, den Fehlerort ermittelt.

Erfindungsgemäß zeichnet sich eine solche Fehlerortungseinrichtung dadurch aus, dass die Auswerteinheit dazu eingerichtet ist, durch Differenzbildung zwischen den zweiten fiktiven Referenzspannungswerten und den ersten Referenzspannungswerten ein erstes fiktives Fehlerspannungssignal und durch Differenzbildung zwischen den ersten fiktiven Referenzspannungswerten und den zweiten Referenzspannungswerten ein zweites fiktive Fehlerspannungssignal zu ermitteln, die beiden fiktiven Fehlerspannungssignale einer Kreuzkorrelation zu unterziehen und eine Kreuzkorrelationsfunktion zu ermitteln und anhand der Kreuzkorrelationsfunktion den Fehlerort zu ermitteln, indem der Fehlerort anhand der zeitlichen Verschiebung des Maximums der Kreuzkorrelationsfunktion gegenüber *der* Mittelposition im Ergebnisfenster der Kreuzkorrelationsfunktion bestimmt wird.

Bezüglich der erfindungsgemäßen Fehlerortungseinrichtung sei auf die obigen Ausführungen im Zusammenhang mit dem erfindungsgemäßen Verfahren verwiesen.

Vorteilhaft ist es, wenn die Fehlerortungseinrichtung zur Bildung des ersten und des zweiten fiktiven Fehlerspannungssignals einen oder mehrere Differenzbildner umfasst, der bzw. die durch Differenzbildung zwischen den zweiten fiktiven Referenzspannungswerten und den ersten Referenzspannungswerten das erste fiktive Fehlerspannungssignal und durch Differenzbildung zwischen den ersten fiktiven Referenzspannungswerten und den zweiten Referenzspannungswerten das zweite fiktive Fehlerspannungssignal bilden.

Darüber hinaus ist es vorteilhaft, wenn die Auswerteinheit einen Kreuzkorrelator, der die beiden fiktiven Fehlerspannungssignale einer Kreuzkorrelation unterzieht und eine Kreuzkorrelationsfunktion ermittelt, eine Maximalwertbestimmungseinrichtung, die das Maximum der Kreuzkorrelationsfunktion und den zugehörigen Zeitversatz ermittelt, und eine Positionsbestimmungseinrichtung, die anhand des Zeitversatzes den Fehlerort bestimmt, umfasst.

Besonders einfach und vorteilhaft lässt sich die Fehlerortungseinrichtung durch eine Recheneinrichtung, insbesondere eine Mikroprozessoreinrichtung, und einen mit dieser verbundenen Speicher bilden. Der Speicher weist vorzugsweise eine Vielzahl an Softwaremodulen auf, von denen - bei Ausführung durch die Recheneinrichtung - eines oder mehrere die Referenzspannungsbildner zur Bildung der ersten und zweiten Referenzspannungswerte, eines oder mehrere die Propagationsnachbildner zur Bildung der fiktiven ersten und zweiten Referenzspannungswerte, eines oder mehrere die Differenzbildner, eines oder mehrere die Schwellwertvergleichseinrichtungen und eines oder mehrere die Auswerteinheit, insbesondere deren Kreuzkorrelator, deren Maximalwertbestimmungseinrichtung und deren Positionsbestimmungseinrichtung, bilden.

Die Erfindung wird nachfolgend anhand von Ausführungsbeispielen näher erläutert; dabei zeigen beispielhaft:

Figur 1    ein Ausführungsbeispiel für eine Fehlerortungseinrichtung, bei der eine Bildung von Referenzspannungswerten und fiktiven Referenzspannungswerten im Frequenzbereich erfolgt,

Figur 2    ein Ausführungsbeispiel für eine Fehlerortungseinrichtung, bei der eine Bildung von Referenzspannungswerten und fiktiven Referenzspannungswerten im Zeitbereich erfolgt,

Figur 3    einen beispielhaften Verlauf einer Kreuzkorrelationsfunktion, die durch Kreuzkorrelation zweier Fehlerspannungssignale gebildet wurde,

Figur 4    einen typischen qualitativen Verlauf des Betrags des Wellenwiderstands einer elektrischen Leitung über der Frequenz,

Figur 5    ein Wellenübertragungsmodell für eine elektrische Leitung im Falle eines elektrischen Fehlers auf der Leitung,

Figur 6    ein elektrisches Ersatzschaltbild einer dreiphasigen elektrischen Leitung mit gekoppelten Phasenleitern und

Figur 7    ein Ausführungsbeispiel für eine Fehlerortungseinrichtung, die durch eine Rechnereinrichtung und einen Speicher gebildet ist bzw. diese Komponenten zumindest auch umfasst.

In den Figuren werden für identische oder vergleichbare bzw. funktionsähnliche Komponenten dieselben Bezugszeichen verwendet.

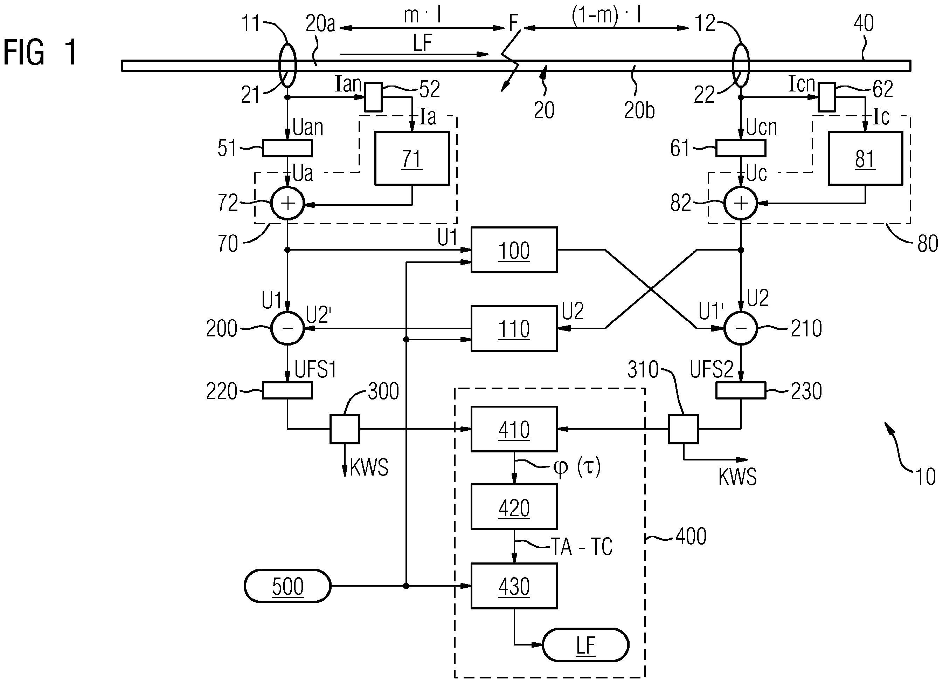

Die Figur 1 zeigt ein Ausführungsbeispiel für eine Fehlerortungseinrichtung 10, die zum Bestimmen des Fehlerortes F im Falle eines Fehlers, insbesondere Kurzschlusses, auf einer elektrischen Leitung 20 geeignet ist. Die Fehlerortungseinrichtung 10 ist an einer ersten Messstelle 11 an ein erstes Leitungsende 21 der Leitung 20 und an einer Messstelle 12 an ein zweites Leitungsende 22 der Leitung 20 angeschlossen.

Bei der Leitung 20 kann es sich - wie beispielhaft in der Figur 1 gezeigt - um einen Leitungsabschnitt einer längeren Übertragungsleitung 40 handeln; in diesem Falle bilden die Leitungsenden 21 und 22 Abschnittsenden des mit der Fehlerortungseinrichtung 10 überwachten Abschnitts der Übertragungsleitung 40.

Die Fehlerortungseinrichtung 10 weist eingangsseitig vier Fouriertransformationseinrichtungen 51, 52, 61 und 62 auf.

Die Fouriertransformationseinrichtung 51 rechnet Spannungsabtastwerte *Uan* von der ersten Messstelle 11 bzw. von dem ersten Leitungsende 21 in frequenzbezogene Spannungswerte Ua um.

Die Fouriertransformationseinrichtung 52 rechnet Stromabtastwerte Ian von der ersten Messstelle 11 bzw. von dem ersten Leitungsende 21 in frequenzbezogene Stromwerte *Ia* um.

Die Fouriertransformationseinrichtung 61 rechnet Spannungsabtastwerte *Ucn* von der zweiten Messstelle 12 bzw. von dem zweiten Leitungsende 22 in frequenzbezogene Spannungswerte *Uc* um; und die Fouriertransformationseinrichtung 62 rechnet Stromabtastwerte *Icn* von der zweiten Messstelle 12 bzw. von dem zweiten Leitungsende 22 in frequenzbezogene Stromwerte *Ic* um.

Den beiden Fouriertransformationseinrichtungen 51 und 52 ist ein erster Referenzspannungsbildner 70 nachgeordnet, der ein Multiplizierelement 71 und ein Addierelement 72 aufweist. Das Multiplizierelement 71 und das Addierelement 72 bilden mit den frequenzbezogenen Spannungswerten Ua und den frequenzbezogenen Stromwerten *Ia* für einen vorgegebenen Frequenzbereich, der vorzugsweise einen Bereich von 50 Hz bis 1 MHz abdeckt, erste frequenzbezogene Referenzspannungswerte *U1* für das erste Leitungsende 21 gemäß:

$$U1 = \left(Ua + Ia \cdot Z\left(j\omega\right)\right)$$

wobei *Z(jω)* den frequenzabhängigen Wellenwiderstand der Leitung 20 und ω die Kreisfrequenz bezeichnet.

Den beiden Fouriertransformationseinrichtungen 61 und 62 ist ein zweiter Referenzspannungsbildner 80 nachgeordnet, der ein Multiplizierelement 81 und ein Addierelement 82 aufweist. Das Multiplizierelement 81 und das Addierelement 82 bilden mit den frequenzbezogenen Spannungswerten *Uc* und den frequenzbezogenen Stromwerten *Ic* zweite frequenzbezogene Referenzspannungswerte *U2* für das zweite Leitungsende 22 gemäß:

$$U2 = \left(Uc + Ic \cdot Z\left(j\omega\right)\right)$$

Ein erster Propagationsnachbildner 100 bildet mit den ersten Referenzspannungswerten *U1* anhand eines vorgegebenen Wellenleitungsmodells, das das Übertragungsverhalten der Leitung 20 beschreibt, für den vorgegebenen Frequenzbereich fiktive erste frequenzbezogene Referenzspannungswerte *U1',* vorzugsweise durch frequenzbezogene Multiplikation gemäß

$$U1' = U1 \cdot e^{j \cdot \gamma\left(j\omega\right) l}$$

wobei *l* die Leitungslänge der Leitung 20 und $\gamma$ die Wellenausbreitungskonstante auf der Leitung 20 bezeichnet.

Die fiktiven ersten Referenzspannungswerte *U1'* sind im fehlerfreien Fall mit den zweiten Referenzspannungswerten *U2* am zweiten Leitungsende 22 identisch oder weichen von diesen zumindest nicht wesentlich ab, weil der Einfluss der elektrischen Leitung durch das Wellenleitungsmodell berücksichtigt ist.

Ein zweiter Propagationsnachbildner 110 bildet mit den zweiten Referenzspannungswerten *U2* anhand des Wellenleitungsmodells in entsprechender Weise für den vorgegebenen Frequenzbereich fiktive zweite frequenzbezogene Referenzspannungswerte *U2'*, vorzugsweise durch frequenzbezogene Multiplikation gemäß

$$U2' = U2 \cdot e^{j \cdot \gamma\left(j\omega\right) l}$$

Die fiktiven zweiten Referenzspannungswerte *U2'* sind im fehlerfreien Fall mit den ersten Referenzspannungswerten *U1* am ersten Leitungsende 21 identisch oder weichen von diesen zumindest nicht wesentlich ab, weil der Einfluss der elektrischen Leitung durch das Wellenleitungsmodell berücksichtigt ist.

Dem Referenzspannungsbildner 70 und dem zweiten Propagationsnachbildner 110 ist ein erster Differenzbildner 200 nachgeordnet, der durch Differenzbildung zwischen den zweiten fiktiven Referenzspannungswerten *U2'* und den ersten Referenzspannungswerten *U1* ein erstes fiktives Fehlerspannungssignal *UFS1* ermittelt gemäß

$$UFS1 = U1 - U2' = U1 - U2 \cdot e^{j \cdot \gamma\left(j\omega\right) l}$$

Dem zweiten Referenzspannungsbildner 80 und dem ersten Propagationsnachbildner 100 ist ein zweiter Differenzbildner 210 nachgeordnet, der durch Differenzbildung zwischen den ersten fiktiven Referenzspannungswerten *U1'* und den zweiten Referenzspannungswerten *U2* ein zweites fiktives Fehlerspannungssignal *UFS2* ermittelt gemäß

$$UFS2 = U2 - U1' = U2 - U1 \cdot e^{j \cdot \gamma\left(j\omega\right) l}$$

Im fehlerfreien Fall bzw. ohne Fehler auf der elektrischen Leitung 20 sind *UFS1* und *UFS2* jeweils gleich Null, oder zumindest näherungsweise jeweils gleich Null.

Eine dem ersten Differenzbildner 200 nachgeordnete inverse Fouriertransformationseinrichtung 220 transformiert das erste fiktive Fehlerspannungssignal *UFS1* in den Zeitbereich, und eine dem Differenzbildner 210 nachgeordnete inverse Fouriertransformationseinrichtung 230 transformiert das zweite fiktive Fehlerspannungssignal *UFS2* in den Zeitbereich.

Die zwei fiktiven Fehlerspannungssignale *UFS1* und *UFS2* werden nach der Transformation in den Zeitbereich von Schwellwertvergleichseinrichtungen 300 und 310 jeweils mit einem Spannungsschwellenwert verglichen, und es wird ein einen Kurzschluss auf der elektrischen Leitung 20 anzeigendes Kurzschlusswarnsignal KWS erzeugt, wenn beide fiktiven Fehlerspannungssignale *UFS1* und *UFS2* oder zumindest eines den Spannungsschwellenwert erreicht oder überschreitet.

Liegt das Kurzschlusswarnsignal KWS vor, so wird ein nachgeordneter Kreuzkorrelator 410 einer Auswerteinrichtung 400 in Betrieb genommen, der die beiden fiktiven Fehlerspannungssignale *UFS1* und *UFS2* einer Kreuzkorrelation unterzieht und eine Kreuzkorrelationsfunktion $\varphi(\tau)$ bildet, beispielsweise bezogen auf das erste Leitungsende 21 der Leitung 20 gemäß:

$$\varphi(\tau) = \frac{1}{T} \sum_{-\frac{T}{2}}^{\frac{T}{2}} UFS1(t) \cdot UFS2(t + \tau)$$

wobei T die zeitliche Länge des Ergebnisfensters der Kreuzkorrelationsfunktion $\varphi(\tau)$ bezeichnet.

Der Zeitversatz $\tau$, für den die Kreuzkorrelationsfunktion $\varphi(\tau)$ maximal wird, ist ein Maß für den zeitlichen Versatz TA-TC, mit dem der Fehlerstrom am Fehlerort F der elektrischen Leitung an dem ersten Leitungsende 21 und dem zweiten Leitungsende 22 sichtbar wird. Mit anderen Worten kann der Fehlerort F anhand der zeitlichen Verschiebung TA-TC des Maximums der Kreuzkorrelationsfunktion gegenüber der Mittelposition im Ergebnisfenster der Kreuzkorrelationsfunktion bestimmt werden.

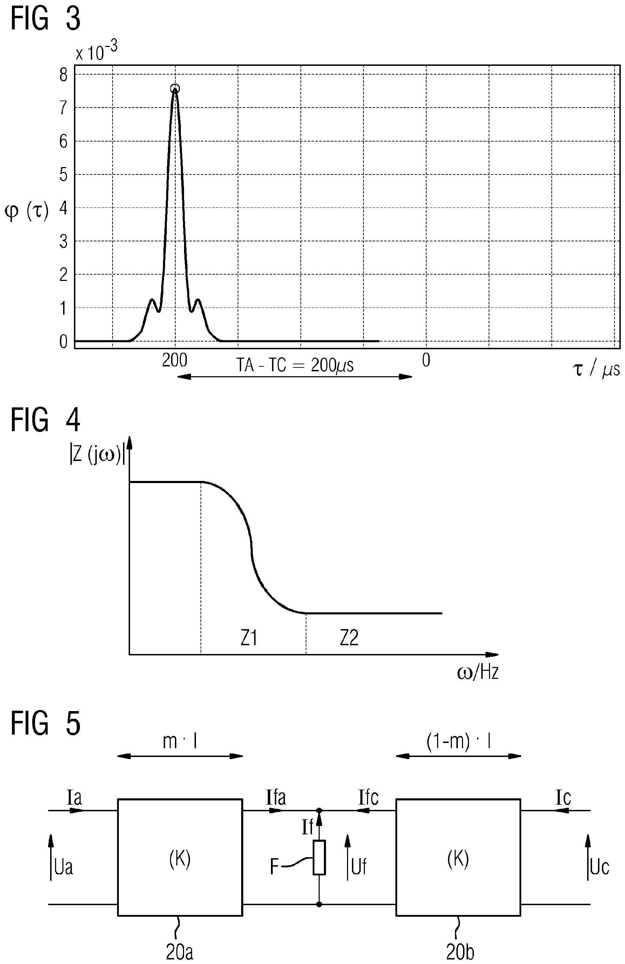

Dies zeigt beispielhaft die Figur 3. Man erkennt einen beispielhaften Verlauf der Kreuzkorrelationsfunktion $\varphi(\tau)$ und einen Versatz TA-TC von 200 $\mu$s, der den Abstand des Fehlerorts von der Leitungsmitte der Leitung 20 anzeigt. Würde der Fehler genau in der Mitte eintreten, wäre der Versatz TA-TC gleich Null; im Falle eines Fehlerorts F nahe einem der beiden Leitungsenden wäre der Versatz TA-TC maximal, wobei das Vorzeichen des Versatzes anzeigt, ob der Fehlerort F gegenüber der Leitungsmitte in Richtung des ersten oder zweiten Leitungsendes versetzt ist.

Das Maximum der Kreuzkorrelationsfunktion $\varphi(\tau)$ wird bei dem Ausführungsbeispiel gemäß Figur 1 von einer Maximalwertbestimmungseinrichtung 420 ermittelt, der eine Positionsbestimmungseinrichtung 430 nachgeordnet ist.

Die Positionsbestimmungseinrichtung 430 bestimmt den Fehlerort F auf der Leitung 20 in Form eines Abstandswertes LF - beispielsweise bezogen auf das erste Leitungsende 21 - vorzugsweise gemäß:

$$LF = m \cdot l = \frac{(\mathrm{Im}(\gamma) \cdot l) + (TA - TC)}{2 \cdot \mathrm{Im}(\gamma) \cdot l}$$

wobei $\mathrm{Im}(\gamma)$ den Imaginärteil der komplexen Ausbreitungskonstanten $\gamma$ der Leitung 20, $l$ die Leitungslänge der Leitung 20 und TA-TC den Zeitversatz $\tau$, für den die Kreuzkorrelationsfunktion $\varphi(\tau)$ maximal wird, bezeichnet.

Zur Parametrierung bzw. Einstellung der Propagationsnachbildner 100 und 110 sowie zur Parametrierung bzw. Einstellung der Positionsbestimmungseinrichtung 430 ist vorzugsweise eine Parametriereinrichtung 500 vorgesehen.

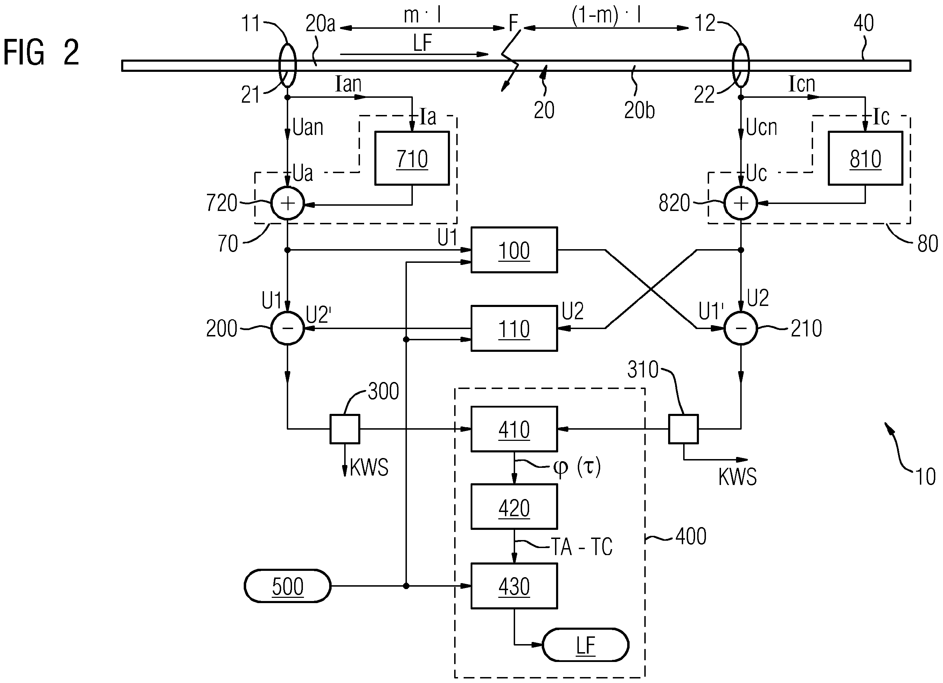

Die Figur 2 zeigt ein weiteres Ausführungsbeispiel für eine Fehlerortungseinrichtung 10, die zum Bestimmen des Fehlerortes F im Falle eines Fehlers, insbesondere Kurzschlusses, auf einer elektrischen Leitung 20 geeignet ist. Wie weiter unten noch näher ausgeführt wird, arbeiten die Referenzspannungsbildner 70 und 80 und die Propagationsnachbildner 100 und 110 im Zeitbereich - im Unterschied zu dem Ausführungsbeispiel gemäß Figur 1, bei dem diese Komponenten im Frequenzbereich arbeiten.

Die Fehlerortungseinrichtung 10 ist an einer ersten Messstelle 11 an ein erstes Leitungsende 21 der Leitung 20 und an einer Messstelle 12 an ein zweites Leitungsende 22 der Leitung 20 angeschlossen und entspricht insoweit dem Ausführungsbeispiel gemäß Figur 1.

Mit der ersten Messstelle 11 steht ein erster Referenzspannungsbildner 70 in Verbindung, der die Spannungsabtastwerte *Uan* und die Stromabtastwerte Ian von der ersten Messstelle 11 unmittelbar als zeitbezogene Spannungswerte Ua und als zeitbezogene Stromwerte *Ia* weiterverwendet.

Der erste Referenzspannungsbildner 70 weist ein erstes Filter 710 und ein Addierelement 720 auf.

Das erste Filter 710 filtert die zeitbezogenen Stromwerte *Ia* im Zeitbereich numerisch derart, dass der zeitliche Verlauf der gefilterten Stromwerte einem Verlauf entspricht, wie er sich bei einer Multiplikation der Stromwerte *Ia* im Frequenzbereich mit dem frequenzabhängigen Wellenwiderstand *Z(jω)* ergeben würde (siehe oben).

Die Frequenzabhängigkeit des frequenzabhängigen Wellenwiderstands *Z(jω)* ist für eine typische Energieübertragungsleitung vereinfacht beispielhaft in Figur 4 gezeigt. Man erkennt einen sehr frequenzabhängigen Bereich Z1, der zwischen ca. 1 Hz und 2 kHz liegt, und einen im Vergleich dazu relativ frequenzunabhängigen Bereich Z2, der sich von ca. 2 kHz bis ca. 1 MHz erstreckt.

Für den Fall, dass das erste Filter 710 beide Bereiche Z1 und Z2 berücksichtigen soll, umfasst das erste Filter 710 vorzugsweise ein IIR-Filter (digitales Filter mit unendlicher Impulsantwort) erster Ordnung und einen nachgeordneten Wurzelbildner.

Für den Fall, dass das erste Filter 710 lediglich den Bereich Z2 berücksichtigen soll, beispielsweise zwecks Minimierung der erforderlichen Rechenleistung, umfasst das erste Filter 710 vorzugsweise ein Multiplizierelement, das die zeitbezogenen Stromwerte mit einem konstanten Wellenwiderstandswert multipliziert.

Das erste Filter 710 und das Addierelement 720 bilden somit mit den zeitbezogenen Spannungswerten Ua und den zeitbezogenen Stromwerten *Ia* für einen vorgegebenen Frequenzbereich erste zeitbezogene Referenzspannungswerte *U1* für das erste Leitungsende 21 gemäß:

$$U1 = \left( Ua + Ia \cdot Z\left( j\omega \right) \right)$$

Mit der zweiten Messstelle 12 steht ein zweiter Referenzspannungsbildner 80 in Verbindung, der die Spannungsabtastwerte *Ucn* und die Stromabtastwerte *Icn* von der zweiten Messstelle 12 unmittelbar als zeitbezogene Spannungswerte *Uc* und zeitbezogene Stromwerte *Ic* weiterverarbeitet.

Der zweite Referenzspannungsbildner 80 weist vorzugsweise ein erstes Filter 810 und ein Addierelement 820 auf, die genau so wie das erste Filter 710 und das Addierelement 720 des ersten Referenzspannungsbildners 70 ausgestaltet sein können. Mit anderen Worten können das erste Filter 810 und das Addierelement 820 des zweiten Referenzspannungsbildners 80 mit dem ersten Filter 710 und dem Addierelement 720 des ersten Referenzspannungsbildners 70 identisch sein.

Das erste Filter 810 des zweiten Referenzspannungsbildners 80 filtert die zeitbezogenen Stromwerte *Ic* im Zeitbereich numerisch derart, dass der zeitliche Verlauf der gefilterten Stromwerte einem Verlauf entspricht, wie er sich bei einer Multiplikation der Stromwerte *Ic* im Frequenzbereich mit dem frequenzabhängigen Wellenwiderstand *Z(jω)* ergeben würde (siehe oben).

Das erste Filter 810 und das Addierelement 820 des zweiten Referenzspannungsbildners 80 bilden somit mit den zeitbezogenen Spannungswerten *Uc* und den zeitbezogenen Stromwerten *Ic* für einen vorgegebenen Frequenzbereich zweite zeitbezogene Referenzspannungswerte *U2* für das zweite Leitungsende 22 gemäß:

$$U2 = \left( Uc + Ic \cdot Z\left( j\omega \right) \right)$$

Ein erster Propagationsnachbildner 100 der Fehlerortungseinrichtung 10 wird vorzugsweise durch ein zweites Filter in Form eines FIR-Filters (digitales Filter mit endlicher Impulsantwort) und/oder eines IIR-Filters gebildet, das die Frequenzabhängigkeit der Dämpfung und die Frequenzabhängigkeit der Ausbreitungskonstanten der elektrischen Leitung 20 berücksichtigt.

Der erste Propagationsnachbildner 100 bildet mit den ersten Referenzspannungswerten *U1* anhand des vorgegebenen Wellenleitungsmodells, das das Übertragungsverhalten der Leitung 20 beschreibt, im Zeitbereich fiktive erste zeitbezogene Referenzspannungswerte U1' in einer Art und Weise, die im Frequenzbereich einer Multiplikation mit dem Term $e^{j \cdot \gamma(j\omega) \cdot l}$ entsprechen würde, so dass man erhält:

$$U1' = U1 \cdot e^{j \cdot \gamma(j\omega) \cdot l}$$

wobei *l* die Leitungslänge der Leitung und $\gamma$ die Wellenausbreitungskonstante auf der Leitung bezeichnet.

Die fiktiven ersten Referenzspannungswerte *U1'* entsprechen im fehlerfreien Fall den zweiten Referenzspannungswerten *U2* am zweiten Leitungsende 22.

Ein zweiter Propagationsnachbildner 110 der Fehlerortungseinrichtung 10 bildet mit den zweiten Referenzspannungswerten *U2* anhand des Wellenleitungsmodells in entsprechender Weise fiktive zweite zeitbezogene Referenzspannungswerte *U2',* und man erhält:

$$U2' = U2 \cdot e^{j \cdot \gamma(j\omega) \cdot l}$$

Die fiktiven zweiten Referenzspannungswerte *U2'* entsprechen im fehlerfreien Fall den ersten Referenzspannungswerten *U1* am ersten Leitungsende 21 bzw. sind mit diesen identisch.

Die beiden Propagationsnachbildner 100 und 110 sind vorzugsweise baugleich oder identisch.

Den Propagationsnachbildnern 100 und 110 sind vorzugsweise Differenzbildner 200 und 210, Schwellwertvergleichseinrichtungen 300 und 310 sowie eine Auswerteinrichtung 400 nachgeordnet, die mit den entsprechenden Komponenten bei dem Ausführungsbeispiel gemäß Figur 1 identisch sein können; diesbezüglich sei daher auf die obigen Ausführungen verwiesen.

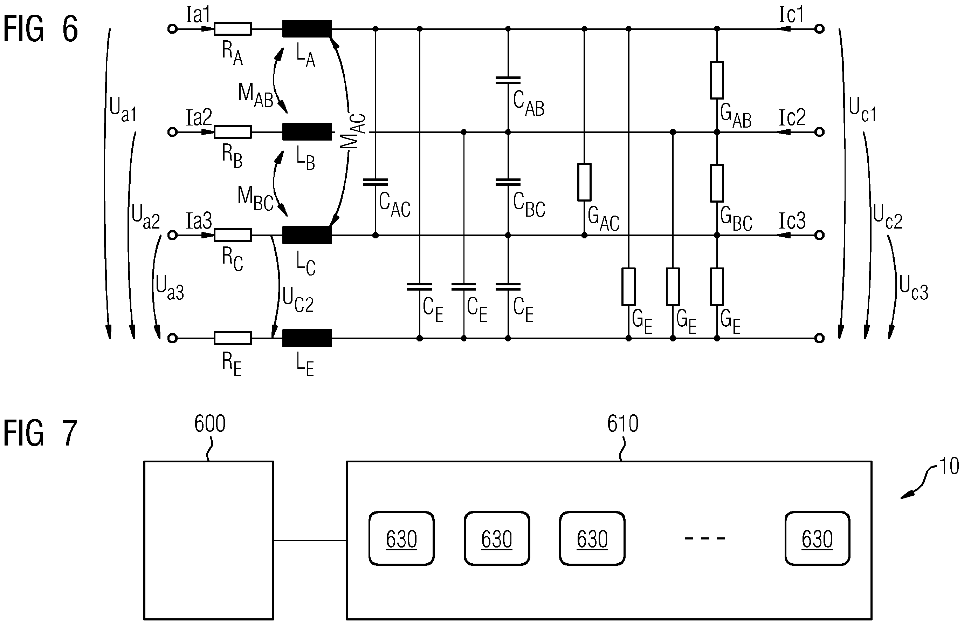

Besonders einfach und vorteilhaft lässt sich die Fehlerortungseinrichtung 10 gemäß den Figuren 1 und 2 durch eine Recheneinrichtung 600, insbesondere eine Mikroprozessoreinrichtung, und einen mit dieser verbundenen Speicher 610 bilden (siehe Figur 7). Der Speicher 610 weist vorzugsweise eine Vielzahl an Softwaremodulen 630 auf, von denen - bei Ausführung durch die Recheneinrichtung 600 - eines oder mehrere die Referenzspannungsbildner 70 und 80 zur Bildung der ersten und zweiten Referenzspannungswerte, eines oder mehrere die Propagationsnachbildner 100 und 110 zur Bildung der fiktiven ersten und zweiten Referenzspannungswerte, eines oder mehrere die Differenzbildner 200 und 210, eines oder mehrere die Schwellwertvergleichseinrichtungen 300 und 310 und eines oder mehrere die Auswerteinheit 400, insbesondere deren Kreuzkorrelator 410, deren Maximalwertbestimmungseinrichtung 420 und deren Positionsbestimmungseinrichtung 430, bilden.

Im Zusammenhang mit der Figur 5 soll das oben beschriebene Prinzip der Fehlerortung auf der Basis des Wellenleitungsmodells anhand der allgemein bekannten Telegraphengleichung näher mathematisch erläutert werden.

Die Leitung 20 gemäß den Figuren 1 und 2 kann unter Heranziehung der Telegraphengleichung durch eine 2x2-Matrix beschrieben werden gemäß:

$$\begin{pmatrix} Uc \\ Ic \end{pmatrix} = (K) \cdot \begin{pmatrix} Ua \\ Ia \end{pmatrix} = \begin{pmatrix} k_{11} & k_{12} \\ k_{21} & k_{22} \end{pmatrix} \cdot \begin{pmatrix} Ua \\ Ia \end{pmatrix}$$

mit

$$K = \begin{pmatrix} \cosh(\gamma(j\omega) \cdot l) & Z_W(j\omega) \cdot \sinh(\gamma(j\omega) \cdot l) \\ \dfrac{1}{Z_W(j\omega)} \cdot \sinh(\gamma(j\omega) \cdot l) & \cosh(\gamma(j\omega) \cdot l) \end{pmatrix}$$

$$Z_W(j\omega) = \sqrt{\frac{R'(j\omega) + i\omega \cdot L'}{G' + i\omega \cdot C'}}$$

und

$$\gamma(j\omega) = \sqrt{(R'(j\omega) + i\omega \cdot L') \cdot (G' + i\omega \cdot C')}$$

wobei R' den längenbezogenen ohmschen Widerstand der Leitung 20, L' die längenbezogene Induktivität der Leitung 20, C' die längenbezogene Kapazität der Leitung 20 und G' den längenbezogenen Leitwert der Leitung 20 bezeichnet.

Tritt nun am Fehlerort F ein Fehler auf, so unterteilt sich die Leitung 20 in einen ersten Abschnitt 20a mit der Länge m*l und einen zweiten Abschnitt 20b mit der Länge (1-m)*l (siehe Figuren 1 und 5). Es gelten für die beiden Abschnitte 20a und 20b nun folgende Beziehungen:

$$Uf = Ifa \cdot Z(j\omega) = (Ua + Ia \cdot Z(j\omega)) \cdot e^{j \cdot \gamma(j\omega) \cdot m \cdot l}$$

$$Uf = Ifc \cdot Z(j\omega) = (Uc + Ic \cdot Z(j\omega)) \cdot e^{j \cdot \gamma(j\omega) \cdot (1-m) \cdot l}$$

und

$$0 = Ifa + Ifc + If$$

Durch Zusammenführen der Gleichungen erhält man:

$$If \cdot Z(j\omega) = (Ua + Ia \cdot Z(j\omega)) \cdot e^{j \cdot \gamma(j\omega) \cdot m \cdot l} - (Uc + Ic \cdot Z(j\omega)) \cdot e^{j \cdot \gamma(j\omega) \cdot (1-m) \cdot l}$$

wodurch die im Zusammenhang mit den Figuren 1 und 2 beschriebene Fehlerortung ermöglicht wird.

Falls es sich bei der Leitung 20 um eine mehrphasige Leitung handelt, bei der die Phasenleiter elektrisch verkoppelt sind, so ist es vorteilhaft, die Phasenleiter zunächst mathematisch zu "entkoppeln"; dies soll nachfolgend am Beispiel einer dreiphasigen Leitung und der Clark-Transformation erläutert werden:

Die Figur 6 zeigt eine dreiphasige Leitung 20, bei der die Leiterphasen durch Koppelinduktivitäten $M_{AB}$, $M_{BC}$, $M_{AC}$, Koppelkapazitäten $C_{AB}$, $C_{BC}$, $C_{AC}$ und Koppelleitwerte $G_{AB}$, $G_{BC}$, $G_{AC}$ miteinander verkoppelt sind.

Für die Phasenspannungen Ua1 bis Ua3 und Uc1 bis Uc3 und die Phasenströme Ia1 bis Ia3 und Ic1 bis Ic3 gilt daher:

$$\begin{pmatrix} Uc1 \\ Uc2 \\ Uc3 \\ Ic1 \\ Ic2 \\ Ic3 \end{pmatrix} = \begin{pmatrix} Y^{-1} \cdot (Y^{-1} + Z)^{-1} & Z \\ Y & Y^{-1} \cdot (Y^{-1} + Z)^{-1} \end{pmatrix} \cdot \begin{pmatrix} Ua1 \\ Ua2 \\ Ua3 \\ Ia1 \\ Ia2 \\ Ia3 \end{pmatrix}$$

mit

$$Z = \begin{pmatrix} R_A & 0 & 0 \\ 0 & R_B & 0 \\ 0 & 0 & R_C \end{pmatrix} + R_E \bullet \begin{pmatrix} 1 & 1 & 1 \\ 1 & 1 & 1 \\ 1 & 1 & 1 \end{pmatrix} + j\omega \cdot \begin{pmatrix} L_A & M_{AB} & M_{AC} \\ M_{AB} & L_B & M_{BC} \\ M_{AC} & M_{BC} & L_C \end{pmatrix} + j\omega L_E \cdot \begin{pmatrix} 1 & 1 & 1 \\ 1 & 1 & 1 \\ 1 & 1 & 1 \end{pmatrix}$$

und

$$Y = \begin{pmatrix} G_{AB} + G_{AC} & -G_{AB} & -G_{AC} \\ -G_{AB} & G_{AB} + G_{BC} & -G_{BC} \\ -G_{AC} & -G_{BC} & G_{AC} + G_{BC} \end{pmatrix} + G_E \cdot \begin{pmatrix} 1 & 0 & 0 \\ 0 & 1 & 0 \\ 0 & 0 & 1 \end{pmatrix}$$

$$+ j\omega \cdot \begin{pmatrix} C_{AB} + C_{AC} & -C_{AB} & -C_{AC} \\ -C_{AB} & C_{AB} + C_{BC} & -C_{BC} \\ -C_{AC} & -C_{BC} & C_{AC} + C_{BC} \end{pmatrix} + j\omega C_E \cdot \begin{pmatrix} 1 & 0 & 0 \\ 0 & 1 & 0 \\ 0 & 0 & 1 \end{pmatrix}$$

Da die Matrizen (Y) und (Z) reelle Eigenwerte aufweisen, kann mit Hilfe bekannter mathematischer Verfahren - insbesondere auf der Basis der Clark-Transformation mit deren Komponenten 0, $\alpha$ und $\beta$ sowie der Methode der Eigenvektoren und einer Matrix-Diagonalisierung - eine Matrix-Entkopplung dergestalt erreicht werden, dass sich für jede Komponente 0, $\alpha$ und $\beta$ die Leitung jeweils durch eine 2x2-Matrix beschreiben und die Fehlerortung wie im Zusammenhang mit den Figuren 1 und 2 beschrieben durchführen lässt.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren zum Bestimmen des Fehlerortes (F) im Falle eines Fehlers, insbesondere Kurzschlusses, auf einer elektrischen Leitung (20) oder einem Leitungsabschnitt der elektrischen Leitung (20), wobei

- mit Strom- und Spannungsabtastwerten (*Uan, Ian*) an einem Leitungsende der Leitung (20) oder des Leitungsabschnitts, nachfolgend erstes Leitungsende (21) genannt, und dem Wellenwiderstand (*Z(jω)*) der Leitung (20) erste Referenzspannungswerte (*U1*) ermittelt werden,
- mit Strom- und Spannungsabtastwerten (*Ucn, Icn*) an dem anderen Leitungsende der Leitung (20) oder des Leitungsabschnitts, nachfolgend zweites Leitungsende (22) genannt, und dem Wellenwiderstand (*Z(jω)*) der Leitung (20) zweite Referenzspannungswerte (*U2*) ermittelt werden,
- anhand eines das Wellenübertragungsverhalten der Leitung (20) beschreibenden Wellenleitungsmodells mit den ersten Referenzspannungswerten (*U1*) fiktive erste Referenzspannungswerte (*U1'*) berechnet werden, die im fehlerfreien Fall den zweiten Referenzspannungswerten (*U2*) am zweiten Leitungsende (22) entsprechen, und mit den zweiten Referenzspannungswerten (*U2*) fiktive zweite Referenzspannungswerte (*U2'*) berechnet werden, die im fehlerfreien Fall den ersten Referenzspannungswerten (*U1*) am ersten Leitungsende (21) entsprechen, und

- mit den ersten und zweiten Referenzspannungswerten (*U1, U2*) und den ersten und zweiten fiktiven Referenzspannungswerten (*U1', U2'*) der Fehlerort (F) ermittelt wird,

**dadurch gekennzeichnet, dass**

- durch Differenzbildung zwischen den zweiten fiktiven Referenzspannungswerten (*U2'*) und den ersten Referenzspannungswerten (*U1*) ein erstes fiktives Fehlerspannungssignal (*UFS1*) und durch Differenzbildung zwischen den ersten fiktiven Referenzspannungswerten (*U1'*) und den zweiten Referenzspannungswerten (*U2*) ein zweites fiktive Fehlerspannungssignal (*UFS2*) ermittelt wird,
- die beiden fiktiven Fehlerspannungssignale (*UFS1, UFS2*) einer Kreuzkorrelation unterzogen werden und eine Kreuzkorrelationsfunktion ($\varphi(\tau)$) ermittelt wird und
- anhand der Kreuzkorrelationsfunktion ($\varphi(\tau)$) der Fehlerort (F) ermittelt wird, indem der Fehlerort (F) anhand der zeitlichen Verschiebung des Maximums der Kreuzkorrelationsfunktion ($\varphi(\tau)$) gegenüber der Mittelposition im Ergebnisfenster der Kreuzkorrelationsfunktion ($\varphi(\tau)$) bestimmt wird.

2. Verfahren nach Anspruch 1,
   **dadurch gekennzeichnet, dass**
   anhand der zeitlichen Verschiebung des Maximums der Kreuzkorrelationsfunktion ($\varphi(\tau)$) gegenüber der Mittelposition im Ergebnisfenster der Kreuzkorrelationsfunktion ($\varphi(\tau)$) ein Laufzeitdifferenzwert (TA-TC) bestimmt wird, der die Laufzeit der Welle des Fehlerstroms vom Fehlerort zu dem jeweiligen von der Kreuzkorrelationsfunktion ($\varphi(\tau)$) als Referenzleitungsende herangezogenen Leitungsende angibt.

3. Verfahren nach Anspruch 1 oder 2,
   **dadurch gekennzeichnet, dass**

   - die fiktiven Fehlerspannungssignale (*UFS1, UFS2*) jeweils mit einem Spannungsschwellenwert verglichen werden und ein einen Kurzschluss auf der elektrischen Leitung (20) anzeigendes Kurzschlusswarnsignal (KWS) erzeugt wird, wenn die beiden fiktiven Fehlerspannungssignale (*UFS1, UFS2*) oder zumindest eines den Spannungsschwellenwert erreicht oder überschreitet, und
   - die beiden fiktiven Fehlerspannungssignale (*UFS1, UFS2*) ausschließlich dann der Kreuzkorrelation unterzogen und die Kreuzkorrelationsfunktion ausschließlich dann ermittelt wird, wenn das Kurzschlusswarnsignal (KWS) erzeugt worden ist.

4. Verfahren nach einem der voranstehenden Ansprüche,
   **dadurch gekennzeichnet, dass**

   - die ersten Referenzspannungswerte ermittelt werden gemäß:

$$U1 = \left(Ua + Ia \cdot Z\left(j\omega\right)\right)$$

wobei *U1* die ersten Referenzspannungswerte, *Ua* Spannungswerte vom ersten Leitungsende, *Ia* Stromwerte vom ersten Leitungsende und *Z(jω)* den Wellenwiderstand bezeichnet,
   - die zweiten Referenzspannungswerte ermittelt werden gemäß:

$$U2 = \left(Uc + Ic \cdot Z\left(j\omega\right)\right)$$

wobei *U2* die zweiten Referenzspannungswerte, *Uc* Spannungswerte vom zweiten Leitungsende und *Ic* Stromwerte vom zweiten Leitungsende bezeichnet,
   - mit den ersten Referenzspannungswerten anhand des Wellenleitungsmodells die fiktiven ersten Referenzspannungswerte berechnet werden gemäß

$$U1' = U1 \cdot e^{j \cdot \gamma(j\omega) \cdot l}$$

wobei $U1'$ die fiktiven ersten Referenzspannungswerte am ersten Leitungsende, l die Leitungslänge der Leitung (20), $\omega$ die Kreisfrequenz und $\gamma$ die Wellenausbreitungskonstante auf der Leitung (20) bezeichnet,
- mit den zweiten Referenzspannungswerten anhand des Wellenleitungsmodells die fiktiven zweiten Referenzspannungswerte berechnet werden gemäß

$$U2' = U2 \cdot e^{j \cdot \gamma(j\omega) \cdot l}$$

wobei $U2'$ die fiktiven zweiten Referenzspannungswerte am zweiten Leitungsende bezeichnet,
- durch Differenzbildung zwischen den zweiten fiktiven Referenzspannungswerten und den ersten Referenzspannungswerten das erste fiktive Fehlerspannungssignal ermittelt wird gemäß:

$$UFS1 = U1 - U2' = U1 - U2 \cdot e^{j \cdot \gamma(j\omega) \cdot l}$$

wobei $UFS1$ das erste fiktive Fehlerspannungssignal bezeichnet, und
- durch Differenzbildung zwischen den ersten fiktiven Referenzspannungswerten und den zweiten Referenzspannungswerten das zweite fiktive Fehlerspannungssignal ermittelt wird gemäß:

$$UFS2 = U2 - U1' = U2 - U1 \cdot e^{j \cdot \gamma(j\omega) \cdot l}$$

wobei $UFS2$ das zweite fiktive Fehlerspannungssignal bezeichnet.

5. Verfahren nach einem der voranstehenden Ansprüche,
**dadurch gekennzeichnet, dass**
die Bestimmung der ersten und zweiten Referenzspannungswerte und/oder die Bestimmung der ersten und zweiten fiktiven Referenzspannungswerte im Frequenzbereich erfolgt.

6. Verfahren nach Anspruch 5,
**dadurch gekennzeichnet, dass**

- bei der Bestimmung der ersten Referenzspannungswerte ($U1$) der Term $Ia \cdot Z(j\omega)$ im Frequenzbereich errechnet wird, indem der Strom $Ia$ am ersten Leitungsende frequenzbezogen mit dem Wellenwiderstand $Z(j\omega)$, insbesondere frequenzabhängig, multipliziert wird und
- bei der Bestimmung der zweiten Referenzspannungswerte der Term $Ic \cdot Z(j\omega)$ im Frequenzbereich errechnet wird, indem der Strom $Ic$ am zweiten Leitungsende frequenzbezogen mit dem Wellenwiderstand $Z(j\omega)$, insbesondere frequenzabhängig, multipliziert wird.

7. Verfahren nach Anspruch 5 oder 6,
**dadurch gekennzeichnet, dass**

- mit den ersten Referenzspannungswerten ($U1$) die fiktiven ersten Referenzspannungswerte ($U1'$) im Frequenzbereich berechnet werden, indem die ersten Referenzspannungswerte ($U1$) mit der Funktion $e^{j \cdot \gamma(j\omega) \cdot l}$ frequenzbezogen multipliziert werden, und
- mit den zweiten Referenzspannungswerten ($U2$) die fiktiven zweiten Referenzspannungswerte ($U2'$) im Frequenzbereich berechnet werden, indem die zweiten Referenzspannungswerte ($U2$) mit der Funktion $e^{j \cdot \gamma(j\omega) \cdot l}$ frequenzbezogen multipliziert werden.

8. Verfahren nach Anspruch 4,
**dadurch gekennzeichnet, dass**
die Bestimmung der ersten und zweiten Referenzspannungswerte und/oder die Bestimmung der ersten und zweiten fiktiven Referenzspannungswerte im Zeitbereich erfolgt.

9. Verfahren nach Anspruch 8,
**dadurch gekennzeichnet, dass**

- bei der Bestimmung der ersten Referenzspannungswerte ($U1$) der Term $Ia \cdot Z(j\omega)$ im Zeitbereich errechnet wird, indem die Stromabtastwerte des Stroms am ersten Leitungsende mit einem das Übertragungsverhalten des Wellenwiderstands $Z(j\omega)$ nachbildenden ersten Filter (710) numerisch gefiltert werden, und
- bei der Bestimmung der zweiten Referenzspannungswerte ($U2$) der Term $Ic \cdot Z(j\omega)$ im Zeitbereich errechnet wird, indem die Stromabtastwerte des Stroms am zweiten Leitungsende mit dem ersten Filter (710) oder einem anderen das Übertragungsverhalten des Wellenwiderstands $Z(j\omega)$ nachbildenden Filter (810) numerisch gefiltert werden.

10. Verfahren nach Anspruch 8 oder 9,
**dadurch gekennzeichnet, dass**

- mit den ersten Referenzspannungswerten ($U1$) die fiktiven ersten Referenzspannungswerte ($U1'$) im Zeitbereich berechnet werden, indem die ersten Referenzspannungswerte ($U1$) mit einem die Funktion $e^{j \cdot \gamma(j\omega) \cdot l}$ nachbildenden zweiten Filter numerisch gefiltert werden, und
- mit den zweiten Referenzspannungswerten ($U2$) die fiktiven zweiten Referenzspannungswerte ($U2'$) im Zeitbereich berechnet werden, indem die zweiten Referenzspannungswerte ($U2$) mit dem zweiten Filter oder einem anderen die Funktion $e^{j \cdot \gamma(j\omega) \cdot l}$ nachbildenden Filter numerisch gefiltert werden.

11. Verfahren nach Anspruch 10,
**dadurch gekennzeichnet, dass**

- das erste Filter ein IIR-Filter erster Ordnung und einen nachgeordneten Wurzelbildner umfasst, wobei das erste Filter die Frequenzabhängigkeit des Wellenwiderstands der elektrischen Leitung (20) berücksichtigt, oder
- das erste Filter ein Multiplizierelement umfasst, das die Stromabtastwerte mit einem konstanten Wellenwiderstandswert multipliziert, wobei das erste Filter die Frequenzabhängigkeit des Wellenwiderstands der elektrischen Leitung (20) unberücksichtigt lässt.

12. Verfahren nach Anspruch 10 oder 11,
**dadurch gekennzeichnet, dass**
das zweite Filter die Frequenzabhängigkeit der Dämpfung und die Frequenzabhängigkeit der Ausbreitungskonstanten der elektrischen Leitung (20) berücksichtigt und ein FIR-Filter und/oder ein IIR-Filter umfasst.

13. Fehlerortungseinrichtung zum Bestimmen des Fehlerortes (F) im Falle eines Fehlers, insbesondere Kurzschlusses, auf einer elektrischen Leitung (20) oder auf einem Leitungsabschnitt der elektrischen Leitung (20), mit

- einem oder mehreren Referenzspannungsbildnern (70, 80) zur Bildung erster und zweiter Referenzspannungswerte ($U1, U2$) anhand von Strom- und Spannungsabtastwerten an einem Leitungsende der Leitung (20) oder des Leitungsabschnitts, nachfolgend erstes Leitungsende (21) genannt, Strom- und Spannungsabtastwerten an dem anderen Leitungsende der Leitung (20) oder des Leitungsabschnitts, nachfolgend zweites Leitungsende (22) genannt, und dem Wellenwiderstand der Leitung (20),
- einem oder mehreren Propagationsnachbildnern (100, 110) zur Bildung fiktiver erster und fiktiver zweiter Referenzspannungswerte ($U1', U2'$) anhand eines das Wellenübertragungsverhalten der Leitung (20) beschreibenden Wellenleitungsmodells sowie den ersten und zweiten Referenzspannungswerten ($U1, U2$), wobei die fiktiven ersten Referenzspannungswerte ($U1'$) im fehlerfreien Fall den zweiten Referenzspannungswerten (U2) am zweiten Leitungsende (22) entsprechen und die fiktiven zweiten Referenzspannungswerte ($U2'$) im fehlerfreien Fall den ersten Referenzspannungswerten ($U1$) am ersten Leitungsende (21) entsprechen, und
- eine Auswerteinheit (400), die mit den ersten und zweiten Referenzspannungswerten ($U1, U2$) und den ersten und zweiten fiktiven Referenzspannungswerten ($U1', U2'$) oder mit ersten und zweiten fiktiven Fehlerspannungssignalen ($UFS1, UFS2$), die mit den ersten und zweiten Referenzspannungswerten und den ersten und zweiten fiktiven Referenzspannungswerten gebildet worden sind, den Fehlerort (F) ermittelt,

**dadurch gekennzeichnet, dass**

- die Auswerteinheit (400) dazu eingerichtet ist, durch Differenzbildung zwischen den zweiten fiktiven Referenzspannungswerten (U2') und den ersten Referenzspannungswerten ($U1$) ein erstes fiktives Fehlerspannungssignal *(UFS1)* und durch Differenzbildung zwischen den ersten fiktiven Referenzspannungswerten (*U1'*) und den zweiten Referenzspannungswerten (U2) ein zweites fiktive Fehlerspannungssignal *(UFS2)* zu ermitteln, die beiden fiktiven Fehlerspannungssignale *(UFS1, UFS2)* einer Kreuzkorrelation zu unterziehen und eine Kreuzkorrelationsfunktion ($\varphi(\tau)$) zu ermitteln und anhand der Kreuzkorrelationsfunktion ($\varphi(\tau)$) den Fehlerort (F) zu ermitteln, indem der Fehlerort (F) anhand der zeitlichen Verschiebung des Maximums der Kreuzkorrelationsfunktion ($\varphi(\tau)$) gegenüber der Mittelposition im Ergebnisfenster der Kreuzkorrelationsfunktion ($\varphi(\tau)$) bestimmt wird.

**Claims**

1. Method for determining the fault location (F) in the case of a fault, in particular a short circuit, on an electric line (20) or a line section of the electric line (20), wherein

   - first reference voltage values (*U1*) are established by means of current and voltage sampled values (*Uan, Ian*) at one line end of the line (20) or line section, referred to as first line end (21) below, and the impedance ($Z(j\omega)$) of the line (20),
   - second reference voltage values (U2) are established by means of current and voltage sampled values (*Ucn, Icn*) at the other line end of the line (20) or line section, referred to as second line end (22) below, and the impedance ($Z(j\omega)$) of the line (20),
   - fictitious first reference voltage values (*U1'*) are calculated on the basis of a wave guiding model, describing the wave response of the line (20), with the first reference voltage values (*U1*), said fictitious first reference voltage values, in the fault-free case, corresponding to the second reference voltage values (U2) at the second line end (22), and fictitious second reference voltage values (*U2'*) are calculated with the second reference voltage values (U2), said fictitious second reference voltage values, in the fault-free case, corresponding to the first reference voltage values (*U1*) at the first line end (21), and
   - the fault location (F) is established by means of the first and second reference voltage values (*U1, U2*) and the first and second fictitious reference voltage values (*U1', U2'*),
   **characterized in that**
   - a first fictitious fault voltage signal (*UFS1*) is established by forming the difference between the second fictitious reference voltage values (*U2'*) and the first reference voltage values (*U1*) and a second fictitious reference voltage signal (*UFS2*) is established by forming the difference between the first fictitious reference voltage values (*U1'*) and the second reference voltage values (*U2*),
   - the two fictitious fault voltage signals (*UFS1, UFS2*) are subject to a cross correlation and a cross correlation function ($\varphi(\tau)$) is established, and
   - the fault location (F) is established on the basis of the cross correlation function ($\varphi(\tau)$) by virtue of the error location (F) being determined on the basis of the temporal shift of the maximum of the cross correlation function ($\varphi(\tau)$) in relation to the mid position in the results window of the cross correlation function ($\varphi(\tau)$).

2. Method according to Claim 1,
   **characterized in that**
   a propagation time difference value (TA-TC) is determined on the basis of the temporal shift of the maximum of the cross correlation function ($\varphi(\tau)$) in relation to the mid position in the results window of the cross correlation function ($\varphi(\tau)$), said propagation time difference value specifying the propagation time of the wave of the fault current from the fault location to the respective line end used by the cross correlation function ($\varphi(\tau)$) as reference line end.

3. Method according to Claim 1 or 2,
   **characterized in that**

   - the fictitious fault voltage signals (*UFS1, UFS2*) are each compared to a voltage threshold and a short-circuit warning signal (KWS) indicating a short circuit on the electric line (20) is generated if the two fictitious fault voltage signals (*UFS1, UFS2*) or at least one thereof reaches or exceeds the voltage threshold, and
   - the two fictitious fault voltage signals (*UFS1, UFS2*) are only subject to the cross correlation and the cross correlation function is only established if the short-circuit warning signal (KWS) was generated.

4. Method according to one of the preceding claims,
   **characterized in that**

- the first reference voltage values are established in accordance with:

$$U1 = \left(Ua + Ia \cdot Z\left(j\omega\right)\right),$$

where $U1$ denotes the first reference voltage values, Ua denotes voltage values from the first line end, $Ia$ denotes current values from the first line end, and $Z(j\omega)$ denotes the impedance,
- the second reference voltage values are established in accordance with:

$$U2 = \left(Uc + Ic \cdot Z\left(j\omega\right)\right),$$

where $U2$ denotes the second reference voltage values, $Uc$ denotes voltage values from the second line end, and $Ic$ denotes current values from the second line end,
- the fictitious first reference voltage values are, on the basis of the wave guiding model, calculated using the fictitious first reference voltage values in accordance with

$$U1' = U1 \cdot e^{j\cdot\gamma\left(j\omega\right)l},$$

where $U1'$ denotes the fictitious first reference voltage values at the first line end, 1 denotes the line length of the line (20), $\omega$ denotes the angular frequency, and $\gamma$ denotes the wave propagation constant on the line (20),
- the fictitious second reference voltage values are, on the basis of the wave guiding model, calculated using the second reference voltage values in accordance with

$$U2' = U2 \cdot e^{j\cdot\gamma\left(j\omega\right)l},$$

where $U2'$ denotes the fictitious second reference voltage values at the second line end,
- the first fictitious fault voltage signal is established by forming the difference between the second fictitious reference voltage values and the first reference voltage values in accordance with:

$$UFS\ 1 = U1 - U2' = U1 - U2 \cdot e^{j\cdot\gamma\left(j\omega\right)l},$$

where $UFS1$ denotes the first fictitious fault voltage signal, and
- the second fictitious fault voltage signal is established by forming the difference between the first fictitious reference voltage values and the second reference voltage values in accordance with:

$$UFS\ 2 = U2 - U1' = U2 - U1 \cdot e^{j\cdot\gamma\left(j\omega\right)l},$$

where $UFS2$ denotes the second fictitious fault voltage signal.

5. Method according to one of the preceding claims,
   **characterized in that**
   the first and second reference voltage values and/or the first and second fictitious reference voltage values are determined in the frequency domain.

6. Method according to Claim 5,
   **characterized in that**

   - the term $Ia \cdot Z(j\omega)$ is calculated in the frequency domain when determining the first reference voltage values (U1) by virtue of the current $Ia$ at the first line end being multiplied, in a frequency-related manner, by the impedance $Z(j\omega)$, in particular in a frequency-dependent manner, and
   - the term $Ic \cdot Z(j\omega)$ is calculated in the frequency domain when determining the second reference voltage values by virtue of the current $Ic$ at the second line end being multiplied, in a frequency-related manner, by the impedance

$Z(j\omega)$, in particular in a frequency-dependent manner.

7.  Method according to Claim 5 or 6,
    **characterized in that**

    - the fictitious first reference voltage values ($U1'$) are calculated in the frequency domain by means of the first reference voltage values ($U1$) by virtue of the first reference voltage values ($U1$) being multiplied by the function $e^{j\cdot\gamma(j\omega)\cdot l}$ in a frequency-related manner, and
    - the fictitious second reference voltage values ($U2'$) are calculated in the frequency domain by means of the second reference voltage values ($U2$) by virtue of the second reference voltage values ($U2$) being multiplied by the function $e^{j\cdot\gamma(j\omega)\cdot l}$ in a frequency-related manner.

8.  Method according to Claim 4,
    **characterized in that**
    the first and second reference voltage values and/or the first and second fictitious reference voltage values are determined in the time domain.

9.  Method according to Claim 8,
    **characterized in that**

    - the term $Ia\cdot Z(j\omega)$ is calculated in the time domain when determining the first reference voltage values ($U1$) by virtue of the current sampled values of the current at the first line end being numerically filtered using a first filter (710) reproducing the response of the impedance $Z(j\omega)$, and
    - the term $Ic\cdot Z(j\omega)$ is calculated in the time domain when determining the second reference voltage values ($U2$) by virtue of the current sampled values of the current at the second line end being numerically filtered using the first filter (710) or another filter (810) reproducing the response of the impedance $Z(j\omega)$.

10. Method according to Claim 8 or 9,
    **characterized in that**

    - the fictitious first reference voltage values ($U1'$) are calculated in the time domain by means of the first reference voltage values ($U1$) by virtue of the first reference voltage values ($U1$) being numerically filtered by the second filter reproducing the function $e^{j\cdot\gamma(j\omega)\cdot l}$, and
    - the fictitious second reference voltage values ($U2'$) are calculated in the time domain by means of the second reference voltage values ($U2$) by virtue of the second reference voltage values ($U2$) being numerically filtered by the second filter, or another filter reproducing the function $e^{j\cdot\gamma(j\omega)\cdot l}$.

11. Method according to Claim 10,
    **characterized in that**

    - the first filter comprises a first order IIR filter and a root former disposed downstream thereof, wherein the first filter takes into account the frequency dependence of the impedance of the electric line (20), or
    - the first filter comprises a multiplication element which multiplies the current sampled values by a constant impedance value, wherein the first filter does not take into account the frequency dependence of the impedance of the electric line (20).

12. Method according to Claim 10 or 11,
    **characterized in that**
    the second filter takes account of the frequency dependence of the damping and the frequency dependence of the propagation constants of the electric line (20) and comprises an FIR filter and/or an IIR filter.

13. Fault locating device for determining the fault location (F) in the case of a fault, in particular a short circuit, on an electric line (20) or on a line section of the electric line (20), having

    - one or more reference voltage formers (70, 80) for forming first and second reference voltage values ($U1, U2$) on the basis of current and voltage sampled values at one line end of the line (20) or line section, referred to as first line end (21) below, current and voltage sampled values at the other line end of the line (20) or line section, referred to as second line end (22) below, and the impedance of the line (20),

- one or more propagation reproducers (100, 110) for forming fictitious first and fictitious second reference voltage values (*U1', U2'*) on the basis of a wave guiding model, describing the wave response of the line (20), and the first and second reference voltage values (*U1, U2*), with the fictitious first reference voltage values (*U1'*), in the fault-free case, corresponding to the second reference voltage values (*U2*) at the second line end (22) and the fictitious second reference voltage values (*U2'*), in the fault-free case, corresponding to the first reference voltage values (*U1*) at the first line end (21), and

- an evaluation unit (400), which establishes the fault location (F) using the first and second reference voltage values (*U1, U2*) and the first and second fictitious reference voltage values (*U1', U2'*) or using first and second fictitious fault voltage signals (*UFS1, UFS2*), which were formed by the first and second reference voltage values and the first and second fictitious reference voltage values,

**characterized in that**

- the evaluation unit (400) is set up to establish a first fictitious fault voltage signal (*UFS1*) by forming the difference between the second fictitious reference voltage values (*U2'*) and the first reference voltage values (*U1*) and to establish a second fictitious reference voltage signal (*UFS2*) by forming the difference between the first fictitious reference voltage values (*U1'*) and the second reference voltage values (*U2*), to subject the two fictitious fault voltage signals (*UFS1, UFS2*) to a cross correlation and to establish a cross correlation function ($\varphi(\tau)$) and to establish the fault location (F) on the basis of the cross correlation function ($\varphi(\tau)$) by virtue of the error location (F) being determined on the basis of the temporal shift of the maximum of the cross correlation function ($\varphi(\tau)$) in relation to the mid position in the results window of the cross correlation function ($\varphi(\tau)$).

**Revendications**

1. Procédé de détermination de l'endroit (F) d'un défaut, dans le cas d'un défaut, notamment d'un court-circuit sur une ligne (20) électrique ou sur un tronçon de la ligne (20) électrique, dans lequel

- on détermine des premières valeurs (U1) de tension de référence par des valeurs (Uan, Ian ) d'échantillonnage de courant et de tension à une extrémité de la ligne (20) ou du tronçon de la ligne, désignée ci-après première extrémité (21) de la ligne, et par l'impédance (Z(jω)) caractéristique de la ligne (20),

- on détermine des deuxièmes valeurs (U2) de tension de référence par des valeurs (Ucn, Icn) de courant et de tension à l'autre extrémité de la ligne (20) ou du tronçon de la ligne, désignée dans ce qui suit deuxième extrémité (22) de la ligne, et par l'impédance (Z(jω)) caractéristique de la ligne (20),

- à l'aide d'un modèle de guidage d'ondes décrivant la propriété de transmission d'ondes de la ligne (20), on calcule, par les premières valeurs ((U1) de tension de référence, de premières valeurs (U1') de tension de référence fictives, qui correspondent, dans le cas où il n'y a pas de défaut, aux deuxièmes valeurs (U2) de tension de référence à la deuxième extrémité (22) de la ligne, et on calcule, par les deuxièmes valeurs (U2) de tension de référence, des deuxièmes valeurs (U2') de tension de référence fictives, qui correspondent, dans le cas où il n'y a pas de défaut, aux premières valeurs (U1) de tension de référence à la première extrémité (21) de la ligne, et

- on détermine l'emplacement (F) du défaut par les premières et deuxièmes valeurs (U1, U2) de tension de référence et par les premières et deuxièmes valeurs (U1, U2) de tension de référence et par les premières et deuxièmes valeurs (U1', U2') de tension de référence fictives,

**caractérisé en ce que**

- on détermine par formation de différence entre les deuxièmes valeurs (U2') de tension de référence fictives et les premières valeurs (U1) de tension de référence, un premier signal (UFS1) de tension de défaut fictif et, par formation de différence entre les premières valeurs (U1') de tension de référence fictives et les deuxièmes valeurs (U2) de tension de référence, un deuxième signal (UFS2) de tension de défaut fictif,

- on soumet les deux signaux (UFS1, UFS2) de tension de défaut fictifs à une corrélation croisée et on détermine une fonction ($\varphi(\tau)$) de corrélation croisée et

- à l'aide de la fonction ($\varphi(\tau)$) de corrélation croisée, on détermine l'emplacement (F) du défaut, en définissant l'emplacement (F) du défaut à l'aide du décalage dans le temps du maximum de la fonction ($\varphi(\tau)$) de corrélation croisée par rapport à la position médiane dans la fenêtre de résultat de la fonction ($\varphi\tau$)) de corrélation croisée.

2. Procédé suivant la revendication 1
**caractérisé en ce que**
à l'aide du décalage dans le temps du maximum de la fonction ($\varphi(\tau)$) de corrélation croisée par rapport à la position médiane dans la fenêtre de résultat de la fonction ($\varphi(\tau)$) de corrélation croisée, on définit une valeur (TA-TC) de différence de temps de parcours, qui indique le temps de parcours de l'onde du courant de défaut, de l'emplacement du défaut à l'extrémité de la ligne, mise à profit la fonction ($\varphi(\tau)$) de corrélation croisée comme extrémité de référence de la ligne.

3. Procédé suivant la revendication 1 ou 2,
   **caractérisé en ce que**

   - on compare les signaux (UFS1, UFS2) de tension de défaut fictifs, respectivement à une valeur de seuil de tension et on produit un signal (KWS) avertissant d'un court-circuit indiquant un court-circuit sur la ligne (20) électrique, si les deux signaux (UFS1, UFS2) de tension de défaut fictif ou au moins l'un d'entre eux atteint ou dépasse la valeur de seuil de tension, et
   - on soumet les deux signaux (UFS1, UFS2) de tension de défaut fictifs exclusivement à la corrélation croisée et on détermine la fonction de corrélation croisée exclusivement lorsque le signal (KWS) avertissant d'un court-circuit a été produit.

4. Procédé suivant l'une des revendications précédentes, **caractérisé en ce que**

   - on détermine les premières valeurs de tension de référence suivantes :

   $$U1 = ( Ua + Ia \cdot Z( j\omega ) )$$

   dans laquelle U1 désigne les premières valeurs de tension de référence, Ua, les valeurs de tension de la première extrémité de la ligne, Ia, les valeurs de courant de la première extrémité de la ligne et Z (j$\omega$), l'impédance caractéristique,
   - on détermine la deuxième valeur de tension de référence suivante :

   $$U2 = ( Uc + Ic \cdot Z( j\omega ) )$$

   dans laquelle U2 désigne les deuxièmes valeurs de tension de référence, Uc, des valeurs de tension de la deuxième extrémité de la ligne et Ic, des valeurs de courant de la deuxième extrémité de la ligne,
   - par les premières valeurs de tension de référence, on calcule à l'aide du modèle de guidage d'ondes, les premières valeurs de tension de référence fictives suivant

   $$U1' = U1 \cdot e^{j \cdot \gamma( j\omega ) \cdot l}$$

   dans laquelle U1' désigne les premières valeurs de tension de référence fictives à la première extrémité de la ligne, l, la longueur de la ligne (20), $\omega$, la pulsation et $\gamma$, la constante de propagation des ondes sur la ligne (20),
   - par les deuxièmes valeurs de tension de référence, on calcule à l'aide du modèle de guidage d'ondes, les deuxièmes valeurs de tension de référence fictives suivant

   $$U2' = U2 \cdot e^{j \cdot \gamma( j\omega ) \cdot l}$$

   dans laquelle U2' désigne des deuxièmes valeurs de tension de référence fictives à la deuxième extrémité de la ligne,
   - par formation de différence entre les deuxièmes valeurs de tension de référence fictives et les premières valeurs de tension de référence, on détermine le premier signal de tension de défaut fictif suivant :

   $$UFS = U1 - U2' = U1 - U2 \cdot e^{j \cdot \gamma( j\omega ) \cdot l}$$

   dans laquelle UFS1 désigne le premier signal de tension de défaut fictif, et
   - par formation de différence entre les premières valeurs de tension de référence fictive et les deuxièmes valeurs de tension de référence, on détermine le deuxième signal de tension de défaut fictif suivant :

$$\text{UFS2} = \text{U2}-\text{U1}' = \text{U2}-\text{U1}\cdot e^{j\cdot\gamma(j\omega)\cdot l}$$

dans laquelle UFS2 désigne le deuxième signal de tension de défaut fictif.

**5.** Procédé suivant l'une des revendications précédentes,
**caractérisé en ce que**
l'on effectue la détermination des première et deuxième valeurs de tension de référence et/ou la détermination des première et deuxième valeurs de tension de référence fictives dans le domaine fréquentiel.

**6.** Procédé suivant la revendication 5,
**caractérisé en ce que**

- lors de la détermination des premières valeurs U1 de tension de référence, on calcule le terme Ia·Z(jω) dans le domaine fréquentiel en multipliant, notamment en fonction de la fréquence, le courant Ia à la première extrémité de la ligne, rapporté en fréquence, à l'impédance Z(jω) caractéristique et
- lors de la détermination des deuxièmes valeurs U2 de tension de référence, on calcule le terme Ic·Z(jω) dans le domaine fréquentiel en multipliant, notamment en fonction de la fréquence, le courant Ic à la deuxième extrémité de la ligne, rapporté en fréquence, à l'impédance Z(jω) caractéristique.

**7.** Procédé suivant la revendication 5 ou 6,
**caractérisé en ce que**

- par les premières valeurs (U1) de tension de référence, on calcule, dans le domaine fréquentiel, les premières valeurs (U1') de tension de référence fictives, en multipliant, rapporté en fréquence, les premières valeurs (U1) de tension de référence par la fonction $e^{j\cdot(j\omega)\cdot l}$, et
- par les deuxièmes valeurs (U2) de tension de référence, on calcule, dans le domaine fréquentiel, les deuxièmes valeurs (U2') de tension de référence fictives, en multipliant, rapporté en fréquence, les deuxièmes valeurs (U2) de tension de référence par la fonction $e^{j\cdot(j\omega)\cdot l}$.

**8.** Procédé suivant la revendication 4,
**caractérisé en ce que**
l'on effectue la détermination des première et deuxième valeurs de tension de référence et/ou la détermination des première et deuxième valeurs de tension de référence fictives dans le domaine temporel.

**9.** Procédé suivant la revendication 8,
**caractérisé en ce que**

- lors de la détermination, des premières valeurs (U1) de tension de référence, on calcule le terme Ia.Z(jω) dans le domaine temporel, en filtrant numériquement les valeurs d'échantillonnage du courant à la première extrémité de la ligne par un premier filtre (710) reproduisant la propriété de transmission de l'impédance Z(jω) caractéristique, et
- lors de la détermination, des deuxièmes valeurs (U2) de tension de référence, on calcule le terme Ic·Z(jω) dans le domaine temporel, en filtrant numériquement les valeurs d'échantillonnage du courant à la deuxième extrémité de la ligne par le premier filtre (710) ou par un autre filtre (810) reproduisant la propriété de transmission de l'impédance Z(jω) caractéristique.

**10.** Procédé suivant la revendication 8 ou 9,
**caractérisé en ce que**

- par les premières valeurs (U1) de tension de référence, on calcule, dans le domaine temporel, les premières valeurs (U1') de tension de référence fictives, en filtrant numériquement les premières valeurs (U1) de tension de référence par un deuxième filtre reproduisant la fonction $e^{j\cdot\gamma(j\omega)\cdot l}$, et
- par les deuxièmes valeurs (U2) de tension de référence, on calcule, dans le domaine temporel, les deuxièmes valeurs (U2') de tension de référence fictives, en filtrant numériquement les deuxièmes valeurs (U2) de tension de référence par le deuxième filtre ou par un autre filtre représentant la fonction e$^{j \cdot \gamma(j\omega) \cdot l}$.

11. Procédé suivant la revendication 10,
    **caractérisé en ce que**

    - le premier filtre comprend un filtre IIR du premier ordre et un formeur de racine en aval, le premier filtre prenant en compte la variation en fonction de la fréquence de l'impédance caractéristique de la ligne (20) électrique, ou
    - le premier filtre comprend un élément multiplicateur, qui multiplie les valeurs d'échantillonnage du courant par une valeur d'impédance caractéristique constante, le premier filtre ne prenant pas en compte la variation en fonction de la fréquence de l'impédance caractéristique de la ligne (20) électrique.

12. Procédé suivant la revendication 10 ou 11,
    **caractérisé en ce que**
    le deuxième filtre prend en compte la variation en fonction de la fréquence de l'atténuation et la variation en fonction de la fréquence de la constante de propagation de la ligne (20) électrique et comprend un filtre FIR et/ou un filtre IIR.

13. Dispositif de localisation d'un défaut pour déterminer l'endroit (F) d'un défaut dans le cas d'un défaut, notamment d'un court-circuit, sur une ligne (20) électrique ou sur un tronçon de la ligne (20) électrique, comprenant

    - un ou plusieurs formeurs (70, 80) de tension de référence pour former des première et deuxième valeurs (U1, U2) de tension de référence à l'aide de valeurs d'échantillonnage de courant et de tension à une extrémité de la ligne (20) ou du tronçon de la ligne, désignée dans ce qui suit première extrémité (21) de la ligne, des valeurs d'échantillonnage de courant et de tension à l'autre extrémité de la ligne (20) ou du tronçon de la ligne, désignée dans ce qui suit deuxième extrémité (22) de la ligne, et de l'impédance caractéristique de la ligne (20),
    - un ou plusieurs simulateurs (100, 110) de propagation pour former des premières et des deuxièmes valeurs (U1', U2') de tension de référence fictives à l'aide d'un modèle de guidage d'ondes décrivant la propriété de transmission des ondes de la ligne (20), ainsi que des première et deuxième valeurs (U1, U2) de tension de référence, les premières valeurs (U1') de tension de référence fictives correspondant, dans le cas où il n'y a pas de défaut, aux deuxièmes valeurs (U2) de tension de référence à la deuxième extrémité (22) de la ligne et les deuxièmes valeurs (U2') de tension de référence fictives correspondant, dans le cas où il n'y a pas de défaut, aux premières valeurs (U1) de tension de référence à la première extrémité (21) de la ligne,
    - une unité (400) d'exploitation, qui détermine l'emplacement (F) du défaut par les première et deuxième valeurs (U1, U2) de tension de référence et par les première et deuxième valeurs (U1', U2') de tension de référence fictives ou par des premier et deuxième signaux (UFS1, UFS2) de tension de défaut fictifs, qui ont été formés par les première et deuxième valeurs de tension de référence et par les première et deuxième valeurs de tension de référence fictives,

    **caractérisé en ce que**

    - l'unité (400) d'exploitation est conçue pour déterminer un premier signal (UFS1) de tension de défaut fictif par formation de différence entre les deuxièmes valeurs (U2') de tension de référence fictives et les premières valeurs (U1) de tension de référence et un deuxième signal (UFS2) de tension de défaut fictif par formation de différence entre les premières valeurs (U1') de tension de référence fictives et les deuxièmes valeurs (U2) de tension de référence, pour soumettre les deux signaux (UFS1, UFS2) de tension de défaut fictifs à une corrélation croisée et pour déterminer une fonction ($\varphi(\tau)$) de corrélation croisée et pour déterminer l'emplacement (F) du défaut à l'aide de la fonction ($\varphi(\tau)$) de corrélation croisée, en définissant l'endroit (F) du défaut, à l'aide du décalage dans le temps du maximum de la fonction ($\varphi(\tau)$) de corrélation croisée par rapport à la position médiane dans la fenêtre de résultat de la fonction ($\varphi(\tau)$) de corrélation croisée.

FIG 1

EP 3 171 185 B1

# FIG 2

EP 3 171 185 B1

FIG 3

FIG 4

FIG 5

FIG 6

FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 68916495 T2
- DE 3687451 T2
- US 5929642 A
- US 8655609 B2